# EUROPÄISCHE PATENTSCHRIFT

(11) **EP 3 300 472 B1**
(45) Veröffentlichungstag und Bekanntmachung des Hinweises auf die Patenterteilung: **14.07.2021**
(21) Anmeldenummer: 17191571.3
(22) Anmeldetag: 18.09.2017
(51) Int. Cl.: H05K 9/00, H01L 23/552

(54) **ELEKTRISCHES BAUTEIL**
ELECTRICAL COMPONENT
COMPOSANT ÉLECTRIQUE

(30) Priorität: 22.09.2016 DE 102016218266
(43) Veröffentlichungstag der Anmeldung: 28.03.2018
(73) Patentinhaber: Continental Automotive GmbH, 30165 Hannover (DE)
(72) Erfinder: Zimmer, Horst, 64832 Babenhausen (DE)
(74) Vertreter: Continental Corporation

(56) Entgegenhaltungen:
- EP-A1- 2 043 149

## Beschreibung

Die Erfindung betrifft ein elektrisches Bauteil, welches zur Oberflächenmontage geeignet ist und eine elektromagnetische Abschirmung aufweist.

Aus der EP 2 043 149 A1 ist ein Bauteil gemäß Oberbegriff des Anspruchs 1 bekannt. Dabei umschließt die Abschirmung das Bauteil sowohl an der Oberseite als auch an den Seitenflächen.

Aufgabe der Erfindung ist es, ein verbessertes Bauteil vorzuschlagen.

Erfindungsgemäß ist vorgesehen, dass die Abschirmung einen über die Seitenfläche des elektrischen Bauteils hinausragenden ersten Vorsprung aufweist. Dies hat den Vorteil, dass nicht nur die elektromagnetische Strahlung abgeschirmt wird, die vom Bauteil emittiert wird, sondern auch Strahlung, die von Bereichen abgegeben wird, die dem Bauteil benachbart sind. Der Vorsprung kann dabei sowohl über eine einzige der Seitenflächen hinausragen, als auch über zwei oder mehrere der Seitenflächen. Bei einem einzigen Vorsprung ist dieser dort vorgesehen, wo besonders starke oder besonders störende elektromagnetische Strahlung emittiert wird. Auch eine geringe Strahlung kann besonders störend sein, wenn störstrahlungsempfindliche Bauteile von ihr getroffen werden. Gibt es zwei oder mehrere Stellen an denen derartige störende Strahlung emittiert wird, so werden entsprechend mehrere Vorsprünge zum Abschirmen dieser Störstrahlung vorgesehen. Vorzugsweise werden zwei oder vier Vorsprünge vorgesehen, die symmetrisch angeordnet sind. Dies hat zum einen den Vorteil, dass entsprechend symmetrisch gelegene Nachbarbereiche des Bauteils abgeschirmt werden. Zum anderen erleichtert es die Montage des Bauteils, da eine um 180° gedrehte Anordnung des Bauteils aufgrund der Symmetrie keine Rolle spielt. Auch wenn in diesem Fall nur ein dem Bauteil benachbarter Bereich einer Abschirmung bedarf, ist es oft günstiger ein Bauteil mit zwei symmetrischen Vorsprüngen zu verwenden, bei dem aber dann nur ein geringerer Montageaufwand erforderlich ist. So kann bei symmetrischer Anordnung zweier Vorsprünge auf das Sicherstellen der korrekten Orientierung eines einzigen Vorsprungs verzichtet werden.

Das elektrische Bauteil ist beispielsweise ein Kondensator, ein Widerstand, eine Induktivität (Spule), ein Transistor, ein integrierter Schaltkreis (IC), eine Diode oder ein anderes elektrisches bzw. elektronisches Bauteil. Ein zur Oberflächenmontage geeignetes Bauteil wird oft auch als SMD (Surface Mounted Device) bezeichnet. Es weist im allgemeinen zumindest zwei Funktionsanschlüsse auf, also Anschlüsse, die zur Funktion des Bauteils benötigt werden. Bei einem einfachen Bauteil wie Kondensator, Widerstand, Induktivität, oder Spule sind es üblicherweise zwei Anschlüsse, bei einem einfachen Transistor drei, bei komplexeren Bauteilen und bei integrierten Schaltkreisen noch mehrere. Die Anschlüsse befinden sich auf der Unterseite des Bauteils oder an dessen Seitenflächen, sodass eine Kontaktierung auf der Unterseite erfolgen kann. Die Unterseite ist üblicherweise zu einer zu kontaktierenden Leiterplatte hin orientiert, also zur Oberflächenmontage vorgesehen. Die elektromagnetische Abschirmung ist beispielsweise ein Metallgehäuse oder eine das Bauteil umschließende metallische Schicht, oder eine andere geeignete Abschirmung. Sie ist insbesondere auf der der Leiterplatte abgewandten Oberseite des Bauteils angebracht, da diese eine große abstrahlende Fläche darstellt, die auch am ehesten benachbarten Bauteilen nahekommt, die vor elektromagnetischer Störstrahlung zu schützen sind. Der Masseanschluss der Abschirmung verbindet diese mit einem definierten Potential. Die Seitenflächen des Bauteils stehen im allgemeinen senkrecht zu dessen Oberseite bzw. Unterseite und auch zur Leiterplatte, auf der das Bauteil zu kontaktieren ist. Hier sind aber auch eine schräge Anordnung, gekrümmte Seitenflächen oder ähnliches möglich.

Vorteilhafterweise ist der Vorsprung in einem ersten Bereich angeordnet, der einem ersten der Funktionsanschlüsse gegenüberliegt. Er liegt an derselben Seitenfläche, an der dieser Funktionsanschluss liegt, oder die diesem benachbart ist. Dies hat den Vorteil, dass die vom Funktionsanschluss ausgehende elektromagnetische Strahlung abgeschirmt wird. Dies ist insbesondere dann von Vorteil, wenn der Funktionsanschluss nicht oder nicht ausschließlich auf der Unterseite des Bauteils angeordnet ist, sondern sich auch zumindest teilweise auf einer der Seitenflächen hin erstreckt. Der Vorsprung der Abschirmung schirmt auch den dem Funktionsanschluss benachbarten Bereich ab, und reduziert so zusätzlich die elektromagnetische Strahlung und damit die Beeinflussung benachbarter Bauteile. Bei einem einseitigen Vorsprung ist dieser vorteilhafterweise dort vorgesehen wo sich ein Anschluss des Bauteils befindet der besonders prädestiniert ist, unerwünschte elektromagnetische Strahlung zu emittieren.

Erfindungsgemäß ist vorgesehen, dass die Abschirmung in einem zweiten Bereich, der keinem der Funktionsanschlüsse gegenüberliegt, zumindest teilweise die Seitenfläche des Bauteils bedeckt. Dies hat den Vorteil, dass eine Abschirmung auch in diesem Bereich der Seitenfläche erfolgt.

Vorteilhafterweise besteht die Abschirmung aus Metallblech. Dies hat den Vorteil, dass der Vorsprung durch die Dicke bzw. Formgebung des Blechs stabil ist und sich im Betrieb auch bei schwankenden Temperaturen, äußeren Belastungen wie Schwingungen, Luftzug oder ähnlichem, nicht oder nur in zulässigem Maße verformt oder in seiner Position verschiebt. Damit ist eine zuverlässige Abschirmung gewährleistet.

Gemäß einer Variante der Erfindung besteht die Abschirmung aus einer Metallschicht, die zumindest im Bereich des Vorsprungs auf ein Trägermaterial aufgebracht ist. Dies hat den Vorteil, dass nur wenig Metall benötigt wird, aber aufgrund des Trägermaterials dennoch die erforderliche Stabilität erreicht wird. Oft reicht eine dünne Metallschicht zu Abschirmzwecken aus, weist aber nicht die erforderliche Stabilität auf, einen Vorsprung zu bilden. Daher besteht der Vorsprung oder die gesamte Abschirmung inklusive Vorsprung aus einem mechanisch stabilen Trägermaterial, auf das eine metallische Abschirmungsschicht aufgebracht ist. Es liegt im Rahmen der Erfindung, die Abschirmung statt aus Metall auch durch ein anderes geeignetes elektromagnetisch abschirmendes Material zu ersetzen, oder ein solches zusätzlich zu verwenden.

Vorteilhafterweise ist das Bauteil dazu vorgesehen, mit einem Schaltknoten verbunden zu werden. Dabei überragt der Vorsprung die elektromagnetische Störstrahlung emittierenden Teile des Schaltknotens. Je größer der Abstand zwischen Vorsprung und Schaltknoten ist, desto größer wird der Überstand sinnvollerweise gewählt. Dies hat den Vorteil einer besonders effektiven Abschirmung, da insbesondere an einem Schaltknoten oft wechselnde Spannungen und damit elektromagnetische Abstrahlung auftritt. Es hat sich herausgestellt, dass es hier auch ausreichend ist, wenn der von oben sichtbare Teil des Schaltknotens vom Vorsprung überragt wird, und von anderen Bauteilen überdeckte Kontaktstellen nicht, oder nur teilweise vom Vorsprung überragt werden. Ein gewisser Abschirmungseffekt wird bereits durch diese Bauteile erzielt. Der Vorsprung kann aber auch der Einfachheit halber rechteckig mit der Breite des Bauteils und einer Länge die der maximalen Ausdehnung des Schaltknotens entspricht ausgelegt werden. Auch andere Formen sind je nach Anwendungsfall sinnvoll verwendbar: eine größere oder kleinere Breite des Vorsprungs, eine größere oder kleinere Länge, ein Vorsprung mit nach unten abknickendem Randbereich, mit abgeschrägten Ecken, mit einer teilweise runde Form oder einer gestuften Form, oder mit anderer geeigneter Form.

Erfindungsgemäß ist das Bauteil eine Induktivität. Induktivitäten sind durch ihre Eigenschaften besonders prädestiniert, an ihrem Schalteingang elektromagnetische Strahlung zu emittieren. Der erfindungsgemäße Vorsprung ist bei dieser Art Bauteil besonders vorteilhaft.

Ein Schaltnetzteil gemäß der Erfindung weist ein erfindungsgemäßes Bauteil mit Vorsprung auf. Gerade bei Schaltnetzteilen ist, beispielsweise aufgrund ihrer kleinen Bauform, die Gefahr elektromagnetischer Strahlungsbeeinflussung von benachbart angeordneten Bauelementen besonders groß. Hier macht sich die erfindungsgemäße Abschirmung mit Vorsprung besonders vorteilhaft bemerkbar.

Erfindungsgemäß ist vorgesehen, die Leiterbahnen eines Schaltnetzteils so anzuordnen, dass ihre zu Inspektionszwecken vorgesehenen Teile nicht vom Vorsprung verdeckt werden. Diese Teile sind beispielsweise Testpunkte, an denen ein Abgriff von außen zu Testzwecken möglich sein soll. Auch Kontaktpunkte benachbarter Elemente, die zur Qualitätskontrolle nach der Montage oder auch im Betrieb sichtbar sein sollten, sind erfindungsgemäß nicht vom Vorsprung verdeckt. Dies hat den Vorteil, dass das Schaltnetzteil getestet und inspiziert werden kann, ohne auf den Vorteil der Abschirmung durch Vorsprung verzichten zu müssen. Die entsprechend nicht abgedeckten Teile sind so auszulegen, dass sie möglichst klein sind bzw. möglichst wenig störende Strahlung abgeben.

Mit anderen Worten befasst sich die Erfindung mit dem Problem, dass Schaltknoten von Schaltnetzteilen elektromagnetische Abstrahlungen mit der Grundwelle und den Oberwellen der Regler-Schaltfrequenz verursachen. Dies führt häufig zu Grenzwertüberschreitungen bei EMV Abstrahlmessungen und erfordert oft eine komplette, kostenintensive Abschirmung des Netzteilbereiches um die geforderten Grenzwerte einhalten zu können. Dazu werden herkömmlicherweise Abschirmgehäuse über dem Netzteil verwendet. Diese sind auf der Leiterplatte anzuordnen, auf der sich das Schaltnetzteil befindet. Erfindungsgemäß wird vorgeschlagen, stattdessen ein Bauteil, hier die Induktivität, mit einer T-förmigen Abschirmung zu versehen, die den Bereich der angrenzenden Schaltung überdeckt, der elektromagnetische Störstrahlung abgibt. Diese Art der Abschirmung des Schaltknotens von Schaltreglern mittels einer in das Bauteil, hier die Induktivität, integrierten Lösung ermöglicht die Vermeidung des kostenintensiven Einsatzes von Abschirmgehäusen.

Die erfindungsgemäße Lösung ist prinzipiell auch dazu geeignet, elektromagnetische Strahlung anderer Wellenbereiche abzuschirmen. Dies kann beispielsweise auch störende Wärmestrahlung, Infrarotlicht oder sichtbares Licht sein, sollte solches beispielsweise bei zukünftigen optoelektronischen Bauteilen störend auftreten.

Weitere Vorteile und Ausgestaltungen der Erfindung ergeben sich auch aus der nachfolgenden Beschreibung anhand von Zeichnungen. Dabei zeigen:
- Fig.1: Bauteil gemäß Stand der Technik in Vorderansicht
- Fig.2: Bauteil gemäß Stand der Technik in Seitenansicht
- Fig.3: Bauteil gemäß Stand der Technik in Seitenansicht
- Fig.4: Bauteil gemäß Stand der Technik in Draufsicht
- Fig.5: erfindungsgemäßes Bauteil in Vorderansicht
- Fig.6: Bauteil gemäß Stand der Technik in Seitenansicht
- Fig.7: erfindungsgemäßes Bauteil in Seitenansicht
- Fig.8: erfindungsgemäßes Bauteil in Seitenansicht
- Fig.9: erfindungsgemäßes Bauteil in Draufsicht
- Fig.10: erfindungsgemäßes Bauteil in Draufsicht
- Fig.11: erfindungsgemäßes Bauteil in Seitenansicht
- Fig.12: Schaltplandetail eines erfindungsgemäßen Schaltnetzteils
- Fig.13: Leiterbahnen eines erfindungsgemäßen Schaltnetzteils
- Fig.14: Leiterbahnen eines erfindungsgemäßen Schaltnetzteils

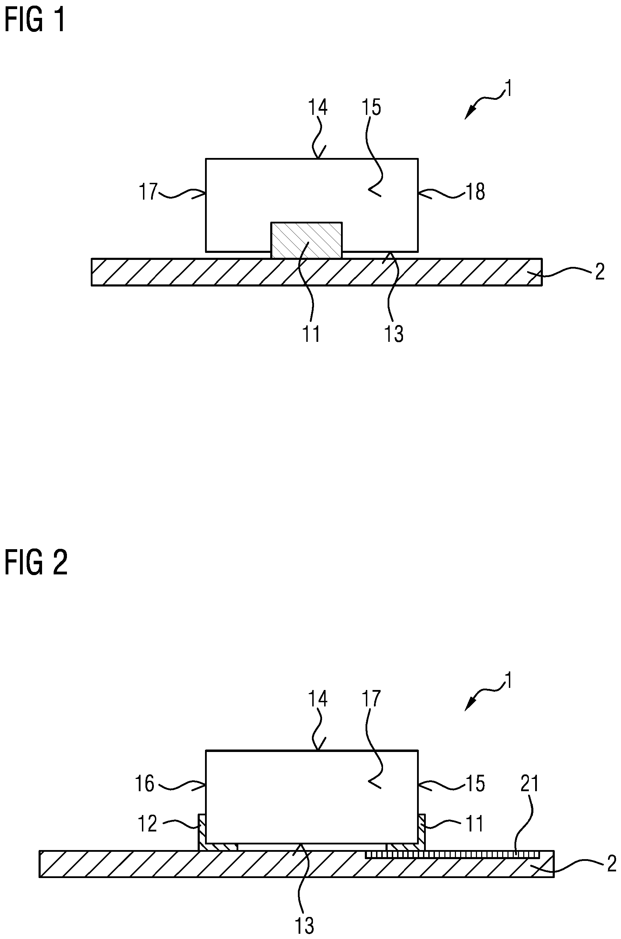

Fig.1 zeigt ein elektrisches Bauteil 1 gemäß Stand der Technik in Vorderansicht, welches zur Oberflächenmontage auf einer Leiterplatte 2 geeignet ist. Man erkennt den vorderen Funktionsanschluss 11, der mit der Leiterplatte 2 in Kontakt steht. Er ist an der Unterseite 13 des Bauteils 1 angeordnet sowie an der vorderen Seitenfläche 15. Die linke Seitenfläche 17 und die rechte Seitenfläche 18 sind nicht mit Anschlüssen versehen.

Fig.2 zeigt das Bauteil 1 gemäß Stand der Technik in Seitenansicht. Man erkennt, dass sich der vordere Funktionsanschluss 11 nicht nur entlang der vorderen Seitenfläche 15 erstreckt, sondern auch ein Stück weit entlang der Unterseite 13. Der vordere Funktionsanschluss 11 grenzt an einen Schaltknoten 21 an, an den er mittels aus der Oberflächenmontagetechnik von SMDs bekannten Art und Weise kontaktiert ist. Der Schaltknoten 21 ist hier in geschnittener Darstellung der Leiterplatte 2 erkennbar und schematisch dargestellt, in korrekter Seitenansicht wäre er nicht oder nur schwach erkennbar. Der hintere Funktionsanschluss 12 ist ebenfalls mit einer Leiterbahn der Leiterplatte 2 kontaktiert, wobei diese Leiterbahn hier nicht dargestellt ist. Der hintere Funktionsanschluss 12 erstreckt sich sowohl über einen Teil der hinteren Seitenfläche 16 als auch über einen Teil der Unterseite 13.

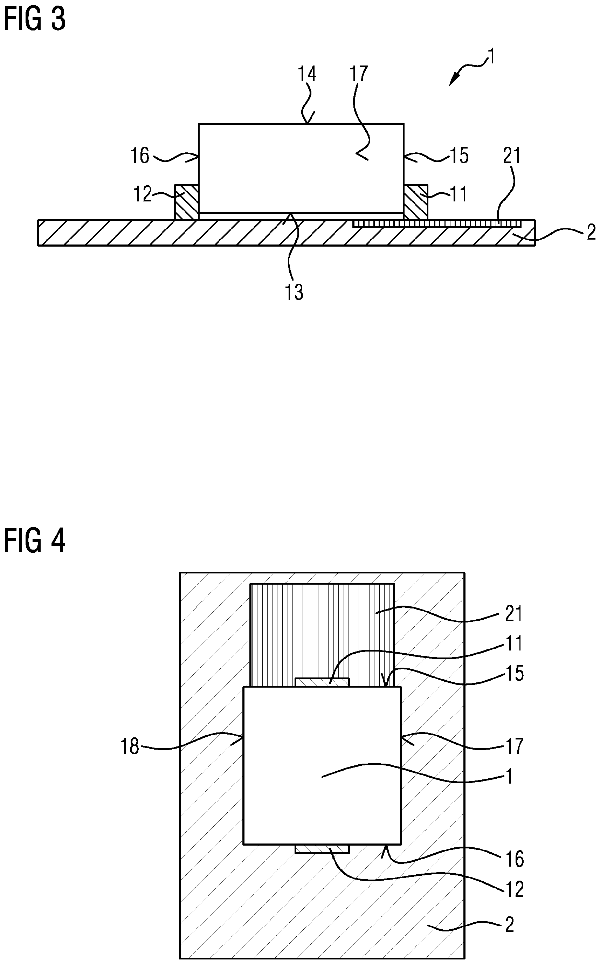

Fig.3 zeigt ein Bauteil gemäß Stand der Technik in Seitenansicht, ähnlich zu Fig.2. Hier erstrecken sich der vordere Funktionsanschluss 11 und der hintere Funktionsanschluss 12 nicht über die Unterseite 13, sondern nur über ein Teil der vorderen Seitenfläche 15 beziehungsweise der hinteren Seitenfläche 16. Sie sind etwas breiter ausgelegt als diejenigen der Fig.2 und stehen mit dem Schaltknoten 21 beziehungsweise mit einer nicht dargestellten anderen Leiterbahn der Leiterplatte 2 in Kontakt.

Fig.4 zeigt ein Bauteil 1 gemäß Stand der Technik in Draufsicht. Man erkennt den vorderen Funktionsanschluss 11 und den hinteren Funktionsanschluss 12, die über die vordere Seitenfläche 15 beziehungsweise die hintere Seitenfläche 16 des Bauteils 1 hinausragen. Der vordere Funktionsanschluss steht in Kontakt mit dem Schaltknoten 21, der eine vergleichsweise große Ausdehnung auf der Leiterplatte 2 hat, und daher prädestiniert ist, elektromagnetische Strahlung zu emittieren. Am Schaltknoten 21 sind weitere, hier nicht dargestellte Bauteile kontaktiert, die zum Ausführen einer Schaltfunktion dienen.

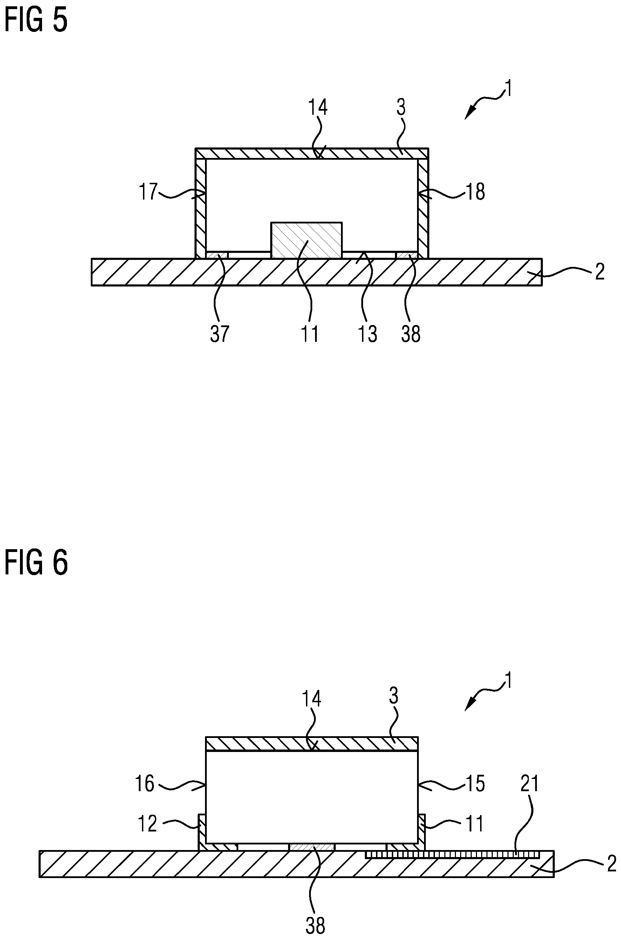

Fig.5 zeigt ein erfindungsgemäßes Bauteil in Vorderansicht, ähnlich zu Fig.1. Man erkennt die elektromagnetische Abschirmung 3, die sich entlang der Oberseite 14, der linken Seitenfläche 17 und der rechten Seitenfläche 18 des Bauteils 1 erstreckt, sowie über Teile der Unterseite 13. Ein linker Masseanschluss 37 und ein rechter Masseanschluss 38 sorgen für eine Verbindung der Abschirmung 3 zu Massepotential bzw. einem anderen definierten Potential. Andere Elemente der Abbildung entsprechen den zu Fig. 1 beschriebenen und werden hier nicht näher erläutert.

Fig.6 zeigt ein Bauteil mit Abschirmung gemäß Stand der Technik in Seitenansicht, ähnlich zu Fig.2. Man erkennt die Abschirmung 3, die sich über die Oberseite 14 erstreckt, aber nicht über die hintere Seitenfläche 16 oder die vordere Seitenfläche 15. In dieser Schnittdarstellung ist nur der rechte Masseanschluss 38, der in der Abbildung hinten liegt, erkennbar.

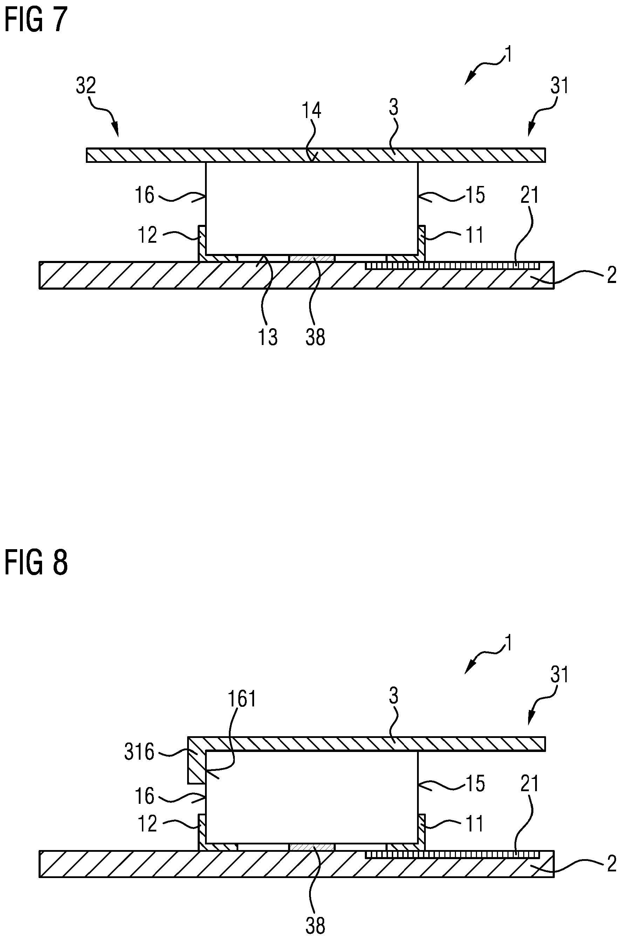

Fig.7 zeigt ein erfindungsgemäßes Bauteil in Seitenansicht, ähnlich zu Fig.6. Hier weist die Abschirmung 3 einen ersten Vorsprung 31 und einen zweiten Vorsprung 32 auf. Der Vorsprung 31 ragt über die vordere Seitenfläche 15 so weit hinaus, dass er die gesamte Fläche des Schaltknotens 21 in senkrechter Projektion gesehen abdeckt. Der zweite Vorsprung 32 ist symmetrisch zum ersten Vorsprung 31 angeordnet und überragt den hier nicht dargestellten Knoten, an dem der hintere Funktionsanschluss 12 kontaktiert ist, weit. Dieser Anschluss ist wesentlich kleiner als der Schaltknoten 21 und hätte daher keine derartige Abschirmung erfordert. Aus Gründen der einfachen Montage ist aber der zweite Vorsprung 32 symmetrisch zum ersten Vorsprung 31 ausgelegt.

Fig.8 zeigt ein erfindungsgemäßes Bauteil in Seitenansicht, ähnlich zu demjenigen der Fig.7. Hier ist nur ein Vorsprung 31 der Abschirmung 3 vorgesehen. Er befindet sich an der vorderen Seitenfläche 15, den Schaltknoten 21 überragend. An der hinteren Seitenfläche 16 ist die Abschirmung 3 in einem Bereich 161 der hinteren Seitenfläche 16 diese überdeckend angeordnet. Die Abschirmung 3 weist dazu einen sich nach unten erstreckenden Bereich 316 auf.

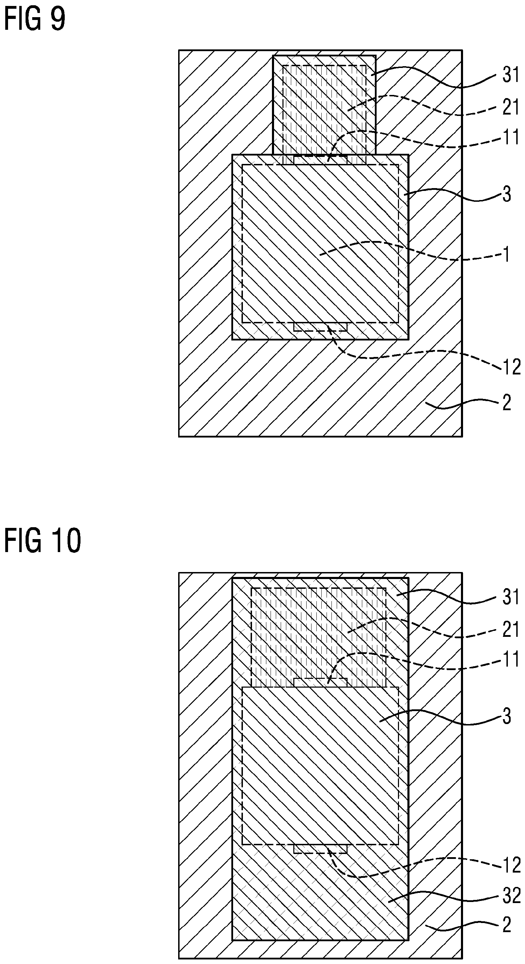

Fig.9 zeigt ein erfindungsgemäßes Bauteil 1 in Draufsicht. Man erkennt die Abschirmung 3 mit Vorsprung 31, der eine geringere Breite als der Hauptteil der Abschirmung 3 aufweist. Gestrichelt dargestellt sind der Körper des Bauteils 1, der vordere Funktionsanschluss 11 und der hintere Funktionsanschluss 12 sowie der Schaltknoten 21, die von der Abschirmung verdeckt werden. Die Leiterplatte 2 ist von dieser nur teilweise verdeckt. Der Vorsprung 31 ist so dimensioniert, dass er den Schaltknoten 21 komplett überdeckt.

Fig.10 zeigt ein erfindungsgemäßes Bauteil in Draufsicht ähnlich zu Fig.9. Hier weist die Abschirmung 3 sowohl einen ersten Vorsprung 31 als auch einen zweiten Vorsprung 32 auf, die die gleiche Breite wie der Hauptteil der Abschirmung 3 aufweisen. Der hier breiter als in Fig. 9 ausgelegte Schaltknoten 21 wird von der Breite des ersten Vorsprungs 31 komplett überdeckt.

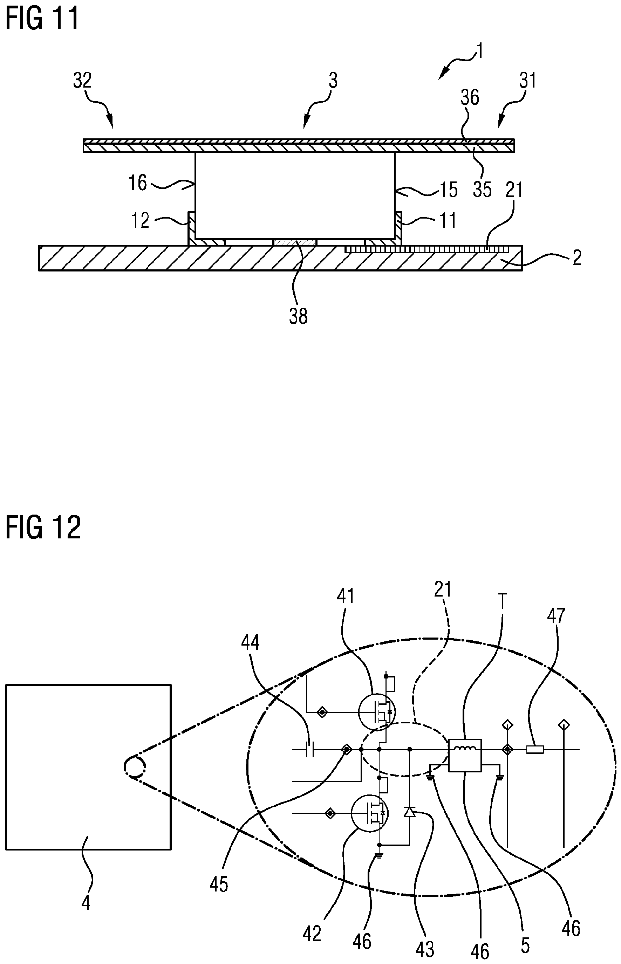

Fig.11 zeigt ein erfindungsgemäßes Bauteil in Seitenansicht. Hier besteht die Abschirmung 3 aus einem Trägermaterial 35, welches mit einer Metallschicht 36 beschichtet ist. Die Beschichtung ist hier nur an der Oberseite des Trägermaterials 35 gezeigt, gemäß einer nicht dargestellten Variante erstreckt sie sich auch über deren Unterseite und gegebenenfalls auch entlang der Seitenflächen 15,16, 17,18 des Bauteils 1. Die Metallschicht 36 steht mit dem Masseanschluss 38 in Verbindung und ist über diesen mit definiertem Potential verbunden.

Fig.12 zeigt ein Schaltplandetail eines erfindungsgemäßen Schaltnetzteils 4, welches hier nur schematisch angedeutet ist. Als Bauteil 1 ist hier eine Induktivität 5 vorgesehen. Sie steht über den gepunktet hervorgehobenen Schaltknoten 21 mit einem ersten Transistor 41 und einem zweiten Transistor 42, eine Diode 43, einem Kondensator 44 und einem Testpunkt 45 in Verbindung.

Aufgrund der vielen mit ihm in Verbindung stehenden Bauteile weist die den Schaltknoten 21 bildende Leiterbahn eine große Oberfläche auf, die aufgrund der Schaltfunktion der Transistoren 41,42 dazu prädestiniert ist, elektromagnetische Strahlung abzugeben, welche benachbarte Bauteile, insbesondere dem Schaltnetzteil 4 benachbarte Bauteile, störend beeinflusst. Die erfindungsgemäße Induktivität 5 ist daher mit einer Abschirmung mit Vorsprung versehen, die hier im Schaltplan nur symbolisch mit einem T angedeutet ist. Die Bezeichnung T weist auf die T-förmige Ausgestaltung der Abschirmung mit zwei Vorsprüngen hin. Masseanschluss 46, Widerstand 47 und die weiteren, hier nicht dargestellten Bauteile des Schaltplans sind zum Verständnis der Erfindung nicht erforderlich und werden daher hier nicht näher beschrieben.

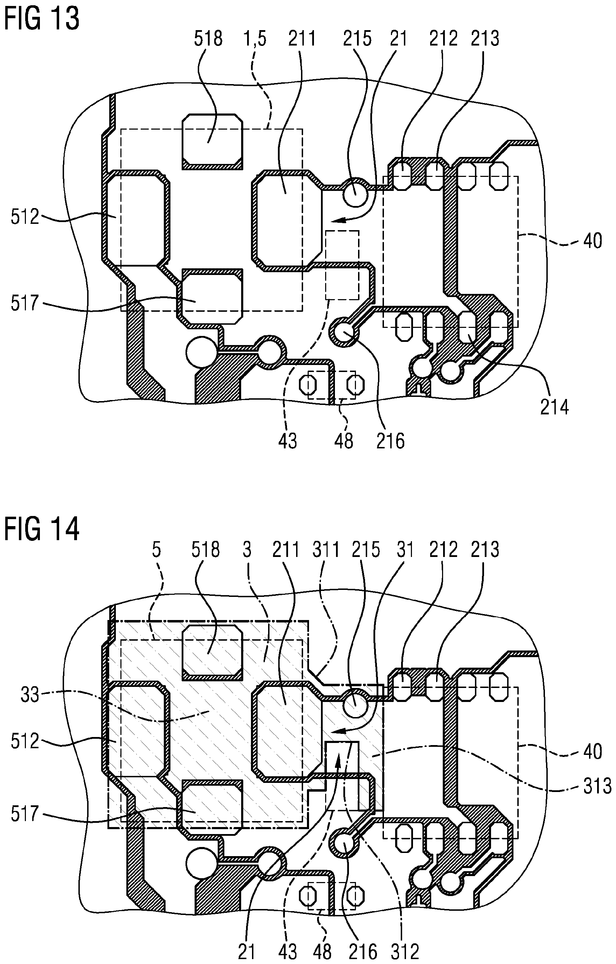

Fig.13 zeigt einen Ausschnitt der Leiterbahnen eines erfindungsgemäßen Schaltnetzteils. Dabei sind die Leiterbahnen weiß dargestellt, die Grenzen zwischen ihnen fett schwarz. Gestrichelt dargestellt ist die Position der Induktivität 5 des Bauteils 1, der innerhalb eines integrierten Schaltkreises 40 angeordneten Transistoren 41,42, der Diode 43 und eines weiteren Bauteils 48. Man erkennt den Schaltknoten 21 mit Kontaktfläche 211 zum Kontaktieren des vorderen Funktionsanschlusses 11, Kontaktflächen 212, 213, 214 zum Kontaktieren des integrierten Schaltkreises 40 und von Testpunkten 215, 216. Für den hinteren Funktionsanschluss 12 der Induktivität 5 ist eine Kontaktfläche 512 vorgesehen, für den linken Masseanschluss 37 eine Kontaktfläche 517, und für den rechten Masseanschluss 38 eine Kontaktfläche 518. Der Testpunkt 215 dient zum Testen des Schaltknotens 21. Der Testpunkt 216 ist ebenfalls dafür vorgesehen, liegt aber etwas weiter beanstandet von der Hauptfläche des Schaltknotens 21. Er wird nicht von dem Vorsprung 31 der Abschirmung 3 überdeckt, siehe dazu auch die folgende Abbildung.

Fig.14 zeigt Leiterbahnen entsprechend Fig.13, hier aber mit der Darstellung der Abschirmung 3. Ihr Umfang ist strichpunktiert dargestellt, ihre Fläche schraffiert. Bis auf die Abschirmung 3 sind alle Elemente mit der vorhergehenden Abbildung identisch. Der Hauptteil 33 der Abschirmung 3 erstreckt sich im wesentlichen über der Induktivität 5. An ihn schließt sich nach rechts der Vorsprung 31 an. Dieser weist eine komplexere Form auf als die zu den vorhergehenden Abbildungen gezeigten Vorsprünge. In seinem in der Darstellung oberen, an den Hauptteil 33 angrenzenden Bereich weist er eine Abschrägung 311 auf, die der darunter befindlichen Form des Schaltknotens 21 entspricht. Der Vorsprung 31 weist eine Ausnehmung 312 auf, sodass die Diode 43 nicht bedeckt, und somit einer visuellen Inspektion zugänglich ist. Der Testpunkt 215 hingegen wird vom Vorsprung 31 bedeckt. Dafür wird der Testpunkt 216 nicht bedeckt, und steht zum Kontaktieren mit einem Testgerät zur Verfügung. Der vordere Abschnitt 313 des Vorsprungs 31 weist eine größere Breite als dessen direkt an den Hauptteil 33 grenzender Bereich auf. Damit wird die in diesem Bereich liegende Form des Schaltknotens 21 soweit abgedeckt, dass eine möglichst gute Abschirmung erzielt wird und dennoch der Testpunkt 216 gut zugänglich ist. Die hier dargestellte relativ komplexe Form des Vorsprungs 31 ist der bestehenden Form der Leiterbahnen des Schaltknotens 21 angepasst. Vorteilhafterweise wird eine einfachere Form des Vorsprungs 31 dadurch möglich, dass die Form des Schaltknotens 21 und der benachbarten Leiterbahnen umgestaltet wird, und gegebenenfalls Bauteile wie die Diode 43 etwas versetzt angeordnet werden. Falls keine optische Inspektion der Diode 43 oder entsprechender Bauteile erforderlich ist, können diese problemlos vom Vorsprung 31 überragt werden. Dies ist beides hier nicht dargestellt. Es versteht sich, dass die oben dargestellten Varianten auch abgewandelt und in anderer Kombination erfindungsgemäß einsetzbar sind.

## Patentansprüche

1. Elektrisches Bauteil welches zur Oberflächenmontage geeignet ist, mit zumindest zwei Funktionsanschlüssen (11,12) an einer Unterseite (13) des Bauteils (1), mit einer elektromagnetischen Abschirmung (3), die an einer Oberseite (14) des Bauteils (1) angeordnet und mittels zumindest einem Masseanschluss (37,38) versehen ist, und mit zumindest einer die Oberseite (14) und die Unterseite (13) verbindenden Seitenfläche (15,16,17,18), **dadurch gekennzeichnet, dass** die Abschirmung (3) einen über die Seitenfläche (15,16,17,18) hinausragenden ersten Vorsprung (31) aufweist.

2. Bauteil gemäß Anspruch 1, wobei der Vorsprung (31) in einem ersten Bereich angeordnet ist, der einem ersten der Funktionsanschlüsse (11) gegenüberliegt.

3. Bauteil nach einem der vorhergehenden Ansprüche,
**dadurch gekennzeichnet, dass** die Abschirmung (3) in einem zweiten Bereich, der keinem der Funktionsanschlüsse (11,12) gegenüberliegt, zumindest teilweise die Seitenfläche (15,16,17,18) bedeckt.

4. Bauteil nach einem der vorhergehenden Ansprüche,
**dadurch gekennzeichnet, dass** die Abschirmung (3) aus Metallblech besteht.

5. Bauteil nach einem der vorhergehenden Ansprüche,
**dadurch gekennzeichnet, dass** die Abschirmung (3) aus einer Metallschicht (36) besteht, die im Bereich des Vorsprungs (31,32) auf ein Trägermaterial (35) aufgebracht ist.

6. Bauteil nach einem der vorhergehenden Ansprüche, wobei das Bauteil (1) dazu vorgesehen ist, mit einem Schaltknoten (21) verbunden zu werden, der eine erste flächige Form aufweist, und wobei der Vorsprung (31,32) eine zweite flächige Form aufweist, die in senkrechter Projektion die erste flächige Form überragt.

7. Bauteil nach einem der vorhergehenden Ansprüche,
**dadurch gekennzeichnet, dass** das Bauteil (1) eine Induktivität (5) ist.

8. Schaltnetzteil mit einem Bauteil (1) gemäß einem der vorhergehenden Ansprüche.

9. Schaltnetzteil nach Anspruch 8 mit Leiterbahnen zum Verbinden des Bauteils (1,5) mit anderen Elementen (40,41,42,43,44,45,47,48), wobei die unterhalb des Vorsprungs (31,32) liegenden Leiterbahnen so angeordnet sind, dass ihre zu Inspektionszwecken vorgesehenen Teile (45,216) außerhalb des Bereichs des Vorsprungs (31,32) liegen.

## Claims

1. Electrical component, which is suitable for surface mounting, having at least two functional connections (11, 12) on an underside (13) of the component (1), having an electromagnetic shield (3), which is arranged on a top side (14) of the component (1) and is provided by means of at least one earth connection (37, 38), and having at least one side surface (15, 16, 17, 18) connecting the top side (14) and the underside (13), **characterized in that** the shield (3) has a first protrusion (31) projecting beyond the side surface (15, 16, 17, 18).

2. Component according to Claim 1, wherein the protrusion (31) is arranged in a first region located opposite a first of the functional connections (11).

3. Component according to either of the preceding claims, **characterized in that** the shield (3) at least partly covers the side surface (15, 16, 17, 18) in a second region not located opposite any of the functional connections (11, 12).

4. Component according to one of the preceding claims, **characterized in that** the shield (3) consists of sheet metal.

5. Component according to one of the preceding claims, **characterized in that** the shield (3) consists of a metal layer (36) that is applied to a carrier material (35) in the region of the protrusion (31, 32).

6. Component according to one of the preceding claims, wherein the component (1) is provided to be connected to a switching node (21), which has a first planar shape, and wherein the protrusion (31, 32) has a second planar shape that projects beyond the first planar shape in perpendicular projection.

7. Component according to one of the preceding claims, **characterized in that** the component (1) is an inductance (5) .

8. Switched-mode power supply having a component (1) according to one of the preceding claims.

9. Switched-mode power supply according to Claim 8 having conductor tracks for connecting the component (1, 5) to other elements (40, 41, 42, 43, 44, 45, 47, 48), wherein the conductor tracks located below the protrusion (31, 32) are arranged so that their parts (45, 216) provided for inspection purposes are located outside of the region of the protrusion (31, 32).

## Revendications

1. Composant électrique, lequel est adapté au montage en surface, comprenant au moins deux bornes fonctionnelles (11, 12) au niveau d'un côté inférieur (13) du composant (1), comprenant un blindage électromagnétique (3), qui est disposé au niveau d'un côté supérieur (14) du composant (1) et est pourvu d'au moins une borne de masse (37, 38), et comprenant au moins une surface latérale (15, 16, 17, 18) qui relie le côté supérieur (14) et le côté inférieur (13), **caractérisé en ce que** le blindage (3) possède une première partie saillante (31) qui fait saillie au-dessus de la surface latérale (15, 16, 17, 18).

2. Composant selon la revendication 1, la partie saillante (31) étant disposée dans une première zone qui se trouve en vis-à-vis d'une première des bornes fonctionnelles (11).

3. Composant selon l'une des revendications précédentes, **caractérisé en ce que** le blindage (3) recouvre au moins partiellement la surface latérale (15, 16, 17, 18) dans une deuxième zone qui ne se trouve en vis-à-vis d'aucune des bornes fonctionnelles (11, 12).

4. Composant selon l'une des revendications précédentes, **caractérisé en ce que** le blindage (3) se compose de tôles métalliques.

5. Composant selon l'une des revendications précédentes, **caractérisé en ce que** le blindage (3) se compose d'une couche de métal (36) qui est appliquée dans la zone de la partie saillante (31, 32) sur un matériau porteur (35).

6. Composant selon l'une des revendications précédentes, le composant (1) étant conçu pour être relié à un nœud de commutation (21) qui présente une première forme plane, et la partie saillante (31, 32) présentant une deuxième forme plane qui, en projection verticale, fait saillie au-dessus de la première forme plane.

7. Composant selon l'une des revendications précédentes, **caractérisé en ce que** le composant (1) est une inductance (5).

8. Bloc d'alimentation à découpage comprenant un composant (1) selon l'une des revendications précédentes.

9. Bloc d'alimentation à découpage selon la revendication 8, comprenant des pistes conductrices destinées à relier le composant (1, 5) à d'autres éléments (40, 41, 42, 43, 44, 45, 47, 48), les pistes conductrices qui se trouvent sous la partie saillante (31, 32) étant disposées de telle sorte que leurs parties (45, 216) conçues à des fins d'inspection se trouvent endehors de la zone de la partie saillante (31, 32).
